Europäisches Patentamt

European Patent Office

Office européen des brevets

(11) Publication number: 0 324 121
A1

## EUROPEAN PATENT APPLICATION

(21) Application number: 88120829.2

(22) Date of filing: 13.12.88

(51) Int. Cl.4: C23C 4/10

(30) Priority: 26.12.87 JP 331102/87

(43) Date of publication of application:
19.07.89 Bulletin 89/29

(84) Designated Contracting States:
CH DE FR GB IT LI

(71) Applicant: THE TOKAI UNIVERSITY JURIDICAL
FOUNDATION
28-4, 2-chome, Tomigaya
Shibuya-ku Tokyo(JP)

Applicant: NKK CORPORATION
1-2, 1-chome, Marunouchi Chiyoda-ku
Tokyo(JP)

(72) Inventor: Tachikawa, Kyoji Department of
Materials Science
of THE TOKAI UNIVERSITY JURIDICAL
FOUNDATION 1117
Kitakaname Hiratsuka-City Kanagawa

Pref.(JP)
Inventor: Shinbo, Yukio
c/o NKK CORPORATION 1-2, 1-chome
Marunouchi Chiyoda-ku Tokyo(JP)
Inventor: Matsuda, Yutaka
c/o NKK CORPORATION 1-2, 1-chome
Marunouchi Chiyoda-ku Tokyo(JP)
Inventor: Kabasawa, Makoto
c/o NKK CORPORATION 1-2, 1-chome
Marunouchi Chiiyoda-ku Tokyo(JP)
Inventor: Kosuge, Shigeyoshi
c/o NKK CORPORATION 1-2, 1-chome
Marunouchi Chiiyoda-ku Tokyo(JP)
Inventor: Watanabe, Itaru
c/o NKK CORPORATION 1-2, 1-chome
Marunouchi Chiiyoda-ku Tokyo(JP)

(74) Representative: Henkel, Feiler, Hänzel &
Partner
Möhlstrasse 37
D-8000 München 80(DE)

(54) Method for metallizing superconducting material onto surface of substrate by use of plasma phenomenon.

(57) A method for metallizing a superconducting material onto a surface of a substrate by the use of the plasma phenomenon, which comprises the steps of: continuously supplying an operating gas containing an oxygen gas in an amount of at least 30 vol.% into a bore of a metallizing nozzle from a rear end portion thereof; continuously supplying powder of a composite oxide superconducting material containing a $Cu_xO_y$ radical into the bore of the metallizing nozzle from a tip portion thereof; producing an electric arc in the bore of the metallizing nozzle to convert the operation gas into a high-temperature plasma; melting the powder of the superconducting material supplied into the bore by means of the operating gas converted into plasma; uniformly blowing the thus melted powder of the superconducting material from the metallizing nozzle onto a surface of a substrate by means of a jet of the operating gas converted into plasma to form a film of the superconducting material onto the surface of the substrate; and heating the thus formed film of the superconducting film to a temperature of at least 700°C, and then slowly cooling the thus heated film to the room temperature at a cooling rate of up to 40°C/minute.

# METHOD FOR METALLIZING SUPERCONDUCTING MATERIAL ONTO SURFACE OF SUBSTRATE BY USE OF PLASMA PHENOMENON

## FIELD OF THE INVENTION

The present invention relates to a method for metallizing a superconducting material onto a surface of a substrate by the use of the plasma phenomenon.

## BACKGROUND OF THE INVENTION

Superconducting materials are already practically applied in the form of a superconducting magnet in a particle accelerator, a medical diagnosing instrument and the like. Potential applications of the superconducting materials include an electric power generator, an energy storage, a linear motor car, a magnetic separator, a nuclear fusion reactor, a power transmission cable, and a magentic shielder. In addition, a superconducting element using Josephson effect is expected to be applied in such fields as an ultra-high speed computer, an infrared sensor and a low-noise amplifier. An industrial and social impact that these possible applications would exert upon practical implementation is really unmearsurable.

One of the typical superconducting materials so far developed is an Nb-Ti alloy which is widely used at present as a magnetizing wire. The Nb-Ti alloy has a critical temperature (i.e., a critical temperature from which a superconductive state occurs )(hereinafter simply referred to as "Tc") of 9 K. As a superconducting material having a "Tc" considerably higher than that of the Nb-Ti alloy, a compound-type superconducting material has been developed, including an $Nb_3Sn$ (Tc: 18 K) and $V_3Ga$ (Tc: 15 K) which are now practically employed in the form of a wire.

As a superconducting material having a "Tc" further higher than those of the above-mentioned metal-type and compound-type superconducting materials, a composite oxide superconducting material containing a $Cu_xO_y$ radical has recently been developed. For example, a Y-Ba-Cu-O type superconducting material has a "Tc" of about 93 K. Since liquid nitrogen has a temperature of 77 K, liquid nitrogen available at a lower cost than liquid helium can be used as a cooling medium for the composite oxide superconducting material.

For the purpose of metallizing a composite oxide superconducting material onto a surface of a substrate by the use of the plasma phenomenon, the following method has conventionally been known, which comprises the steps of: continuously supplying an inert gas as an operating gas into a bore of a metallizing nozzle from a rear end portion thereof; continuously supplying powder of a composite oxide superconducting material containing $Cu_xO_y$ radical into said bore of said metallizing nozzle from a tip portion thereof; producing an electric arc in said bore of said metallizing nozzle to convert said operating gas in said bore into a high-temperature plasma; melting said powder of said superconducting material in said bore by means of said operating gas converted into said high-temperature plasma; and uniformly blowing the thus melted powder of said superconducting material from said metallizing nozzle onto a surface of a substrate by means of a jet of said operating gas converted into said high-temperature plasma, thereby forming a film of said superconducting material onto said surface of said substrate.

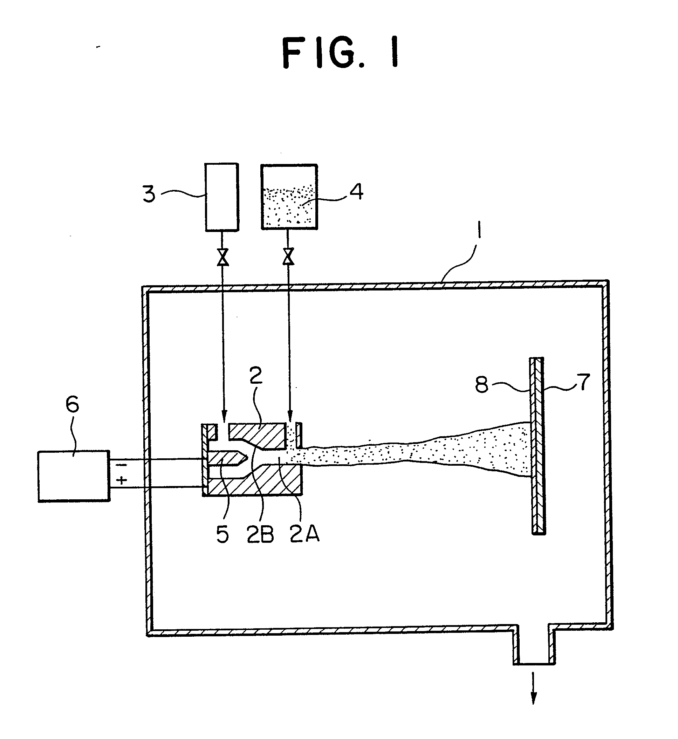

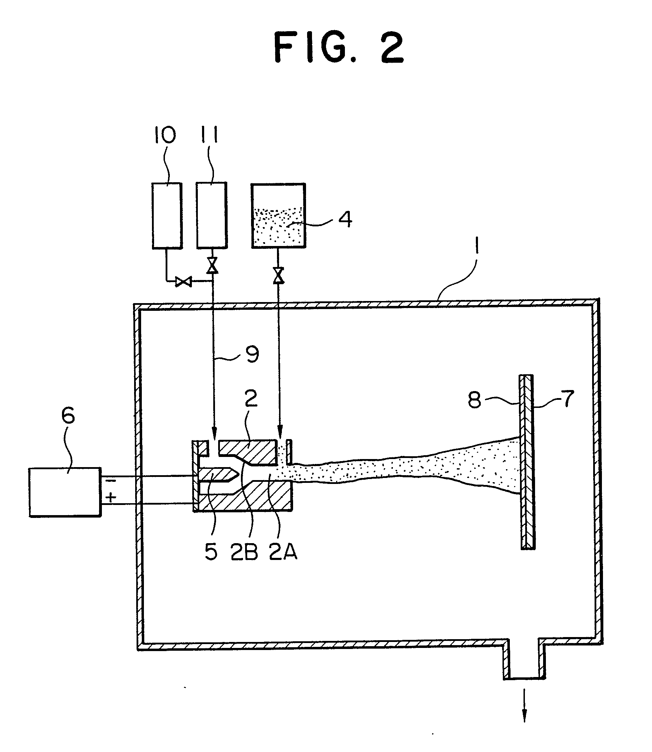

Fig. 1 is a schematic descriptive sectional view illustrating the above-mentioned conventional method for metallizing a superconducting material onto a surface of a substrate by the use of the plasma phenomenon. In Fig. 1, 2 is a metallizing nozzle provided in a container 1, 3 is a pressure tank for storing an operating gas, 4 is a reservoir for storing powder of a superconducting material, 7 is a substrate arranged in the container 1 so as to face the metallizing nozzle 2 and 6 is an electric power source provided outside the container 1.

As shown in Fig. 1, an inert gas such as an argon gas is continuously supplic.' as an operating gas from the pressure tank 3 through a rear end portion of the metallizing nozzle 2 into a bore 2A thereof. Powder of a composite oxide superconducting material such as $Y_1Ba_2Cu_3O_{7-y}$ containing $Cu_xO_y$ radical is continuously supplied from the reservoir 4 through a tip portion of the metallizing nozzle 2 into the bore 2A thereof. An electric current is supplied from the electric power source 6 to an electrode 5 inserted into a rear end portion of the bore 2A of the metallizing nozzle 2 to produce an electric arc between the electrode 5 and an inner surface 2B of the bore 2A of the metallizing nozzle 2 so as to convert the operating gas supplied into the bore 2A into a high-temperature plasma. The powder of the superconducting material supplied into the bore 2A of the metallizing nozzle 2 is melted by means of the operating gas converted into the high-temperature plasma. The thus melted powder of the superconducting material is uniformly blown from the metallizing nozzle 2 onto a surface of the substrate 7 such as a cupper sheet, which is arranged in the container 1 so as to face the metallizing nozzle 2, by means of a jet of the operating gas converted into the high-temperature plasma, whereby a film 8 of the superconducting material is formed on the surface of the substrate 7.

The above-described conventional metallizing method provides advantages, over the vacuum evaporation method and the sputtering method, of a high forming speed of the film of the superconducting material and the possibility of forming a thicker film thereof.

However, the above-mentioned conventional metallizing method has the following problem. It is known that, in a composite oxide superconducting material such as $Y_1Ba_2Cu_3O_{7-y}$, the increase in an amount of oxygen omission "y" makes it impossible to obtain a film 8 of the superconducting material having a high "Tc" and a high critical current density (hereinafter simply referred to as "Jc"), i.e., having an excellent superconducting property. During metallizing of the superconducting material and during heating of the film 8 of the superconducting material after metallizing, oxygen is lost from the superconducting material, resulting in the increase in the amount of oxygen omission "y" of the superconducting material. It is therefore the conventional practice to reduce the amount of oxygen omission of the superconducting material by heating the film 8 thus formed of the superconducting material to a temperature of about 950° C, and then slowly cooling the film 8 at a rate of up to 20° C/minute to cause the superconducting material to absorb oxygen. The film 8 is heated in an attempt to achieve a uniform structure of the superconducting material, intensify the connecting strength of grain boundaries, and increase the adhering strength between the substrate and the film 8. However, even when the film 8 is slowly cooled as mentioned above, oxygen may not sufficiently be absorbed in the superconducting material and a film 8 having an excellent superconducting property may not be obtained.

The above-mentioned problem may be solved by metallizing the composite oxide superconducting material onto the surface of the substrate so that the amount of oxygen omission "y" of the superconducting material decreases in advance prior to applying the above-mentioned slow cooling treatment to the film 8. However, since only an inert gas such as an argon gas is used as the operating gas, the amount of oxygen omission "y" of the superconducting material cannot be reduced in advance prior to applying the above-mentioned slow cooling treatment to the film 8.

Under such circumstances, there is a strong demand for development of a method which permits metallizing of a composite oxide superconducting material onto a surface of a substrate so as to reduce an amount of oxygen omission "y" of the superconducting material, and permits formation of a film of the superconducting material on the surface of the substrate, which has an excellent superconducting property including a "Tc" of at least 90 K and a "Jc" of at least 350 A/cm², but such a metallizing method has not as yet been proposed.

SUMMARY OF THE INVENTION

An object of the present invention is therefore to provide a method which permits metallizing of a composite oxide superconducting material onto a surface of a substrate so as to reduce an amount of oxygen omission "y" of the superconducting material, and permits formation of a film of the superconducting material on the surface of the substrate, which has an excellent superconducting property including a critical temperature "Tc" of at least 90 K and a critical current density "Jc" of at least 350 A/cm².

In accordance with one of the features of the present invention, in a method for metallizing a superconducting material onto the surface of a substrate by the use of the plasma phenomenon, which comprises the steps of:

continuously supplying an operating gas into a bore of a metallizing nozzle from a rear end portion thereof;

continuously supplying powder of a composite oxide superconducting material containing a $Cu_xO_y$ radical into said bore of said metallizing nozzle from a tip portion thereof;

producing an electric arc between an electrode inserted into a rear end portion of said bore and an inner surface of said bore to convert said operating gas supplied into said bore into a high-temperature plasma;

melting said powder of said superconducting material supplied into said bore by means of said operating gas converted into said high-temperature plasma;

uniformly blowing the thus melted powder of said superconducting material from said metallizing nozzle onto a surface of a substrate by means of a jet of said operating gas converted into said high-temperature plasma, to form a film of said superconducting material onto said surface of said substrate; and

heating the thus formed film of said superconducting material to a temperature of at least 700° C, and then slowly cooling said film thus heated to the room temperature at a cooling rate of up to 40° C/minute;

3

there is provided tne improvement characterized by:
mixing an oxygen gas in an amount of at least 30 vol.% into said operating gas.


BRIEF DESCRIPTION OF THE DRAWINGS

Fig. 1 is a schematic descriptive sectional view illustrating the conventional method for metallizing a superconducting material onto a surface of a substrate by the use of the plasma phenomenon; and

Fig. 2 is a schematic descriptive sectional view illustrating an embodiment of the method for metallizing a superconducting material onto a surface of a substrate by the use of the plasma phenomenon of the present invention.


DETAILED DESCRIPTION OF PREFERRED EMBODIMENTS

From the above-mentioned point of view, extensive studies were carried out to develop a method which permits metallizing of a composite oxide superconducting material onto a surface of a substrate so as to reduce an amount of oxygen omission of the superconducting material. As a result, the following finding was obtained. The amount of oxygen omission of a composite oxide superconducting material can be reduced by mixing an oxygen gas in an amount of at least 30 vol.% into an operating gas which is used when metallizing the superconducting material onto a surface of a substrate.

The present invention was made on the basis of the above-mentioned finding. Now, the method for metallizing a superconducting material onto a surface of a substrate by the use of the plasma phenomenon of the present invention is described with reference to the drawings.

Fig. 2 is a schematic descriptive sectional view illustrating an embodiment of the method for metallizing a superconducting material onto a surface of a substrate by the use of the plasma phenomenon of the present invention. In Fig. 2, 2 is a metallizing nozzle provided in a container 1, 10 is a pressure tank for storing an inert gas, 11 is another pressure tank for storing an oxygen gas, 4 is a reservoir for storing powder of a superconducting material, 7 is a substrate arranged in the container 1 so as to face the metallizing nozzle 2, and 6 is an electric power source provided outside the container 1.

As shown in Fig. 2, an operating gas 9 used in the method of the present invention is prepared by mixing an oxygen gas in an amount of at least 30 vol.% from the another pressure tank 11 into an inert gas such as an argon gas from the pressure tank 10. With a mixing rate of the oxygen gas into the inert gas of under 30 vol.%, it is impossible to give to a film of a composite oxide superconducting material, which is formed onto a surface of the substrate 7 as described later, an excellent superconducting property including a critical temperature "Tc" of at least 80 K and a critical current density "Jc" of at least 350 A/cm$^2$. Therefore, the mixing rate of the oxygen gas into the inert gas should be at least 30 vol.%. The thus prepared operating gas 9 is continuously supplied from a rear end portion of the metallizing nozzle 2 into a bore 2A thereof.

Powder of a composite oxide superconducting material such as Y, Ba$_2$Cu$_3$O$_{7-y}$ containing Cu$_x$O$_y$ radical is continuously supplied from the reservoir 4 through a tip portion of the metallizing nozzle 2 into the bore 2A thereof. An electric current is supplied from the electric power source 6 to an electrode 5 inserted into a rear end portion of the bore 2A of the metallizing nozzle 2 to produce an electric arc between the electrode 5 and an inner surface 2B of the bore 2A of the metallizing nozzle 2 so as to convert the operating gas 9 supplied into the bore 2A into a high-temperature plasma. The powder of the superconducting material supplied into the bore 2A of the metallizing nozzle 2 is melted by means of the operating gas 9 converted into the high-temperature plasma. The thus melted powder of the superconducting material is uniformly blown from the metallizing nozzle 2 onto a surface of the substrate 7 such as a cupper sheet, which is arranged in the container 1 so as to face the metallizing nozzle 2, by means of a jet of the operating gas 9 converted into the high-temperature plasma, whereby a film 8 of the superconducting material is formed on the surface of the substrate 7.

As described above, in the method of the present invention, the amount of oxygen omission of the composite oxide superconducting material metallized onto the surface of the substrate 7 is reduced by the use of the operating gas 9 which is prepared by mixing an oxygen gas in an amount of at least 30 vol.% into an inert gas. In the subsequent step of applying a slow cooling treatment to the film 8 of the superconducting material, therefore, even when oxygen is not sufficiently absorbed into the superconducting material, the film 8 having an excellent superconducting property is available because the amount of oxygen omission of the superconducting material has been reduced in advance prior to the slow cooling

4

treatment.

The above-mentioned composite oxide superconducting material includes, in addition to $Y_1Ba_2Cu_3O_{7-y}$, $Bi_{1.7}Pb_{0.3}Sr_2Ca_2Cu_3O_y$.

Now, the method for metallizing a superconducting material onto a surface of a substrate by the use of plasma phenomenon of the present invention is described further in detail by means of examples.

## EXAMPLE 1

As shown in Fig. 2, a cupper substrate sheet 7 having a width of 30 mm, a height of 20 mm and a thickness of 1.0 mm was arranged in a container 1 so as to face a metallizing nozzle 2. An operating gas 9 prepared by mixing an oxygen gas in a certain amount from another pressure tank 11 into an argon gas from a pressure tank 10, was continuously supplied from a rear end portion of the metallizing nozzle 2 into a bore 2A thereof while keeping the pressure in the container 1 at 80 millibars. Powder having a particle size of from 10 to 100 $\mu$m of a composite oxide superconducting material comprising $Y_1Ba_2Cu_3O_{7-y}$ , was continuously supplied from a reservoir 4 through a tip portion of the metallizing nozzle 2 into the bore 2A thereof. An electric power of 25 KWH was supplied from an electric power source 6 provided outside the container 1 to an electrode 5 inserted into a rear end portion of the bore 2A of the metallizing nozzle 2 to produce an electric arc between the electrode 5 and an inner surface 2B of the inner bore 2A of the metallizing nozzle 2 so as to convert the operating gas 9 supplied into the bore 2A into a high-temperature plasma. The powder of the superconducting material supplied into the bore 2A of the metallizing nozzle 2 was melted by means of the operating gas 9 converted into the high-temperature plasma. The thus melted powder of the superconducting material was uniformly blown from the metallizing nozzle 2 onto a surface of the substrate sheet 7 by means of a jet of the operating gas 9 converted into the high-temperature plasma, whereby a film 8 having a thickness of 150 $\mu$m of the superconducting material was formed on the surface of the substrate sheet 7.

Then, the film 8 of the superconducting material thus formed on the surface of the substrate sheet 7 was heated in a heating furnace under an oxygen-containing atmosphere (not shown) provided outside the container 1 to a temperature of 930°C for 30 minutes, and then slowly cooled to the room temperature at a cooling rate of 20°C/minute.

In this example, the mixing rate of the oxygen gas into the argon gas was altered to various levels as shown in Table 1.

Then, a critical temperature "Tc" and a critical current density "Jc" of the film 8 of the superconducting material were investigated. The result is shown in Table 1.

Table 1

| Mixing rate of oxygen gas into argon gas (vol.%) | 20 | 25 | 30 | 60 | 100 |
|---|---|---|---|---|---|
| Critical temperature "Tc" (K) | 87 | 87 | 90 | 90 | 91 |
| Critical current density "Jc" (A/cm²) | 120 | 120 | 350 | 400 | 470 |

As is clear from Table 1, a film 8 having an excellent superconducting property including a "Tc" of at least 90K and a "Jc" of at least 350 A/cm² was obtained by mixing the oxygen gas in an amount of at least 30 vol.% into the argon gas.

## EXAMPLE 2

A film 8 of a composite oxide superconducting material was formed on a surface of a substrate sheet 7 in accordance with the same conditions as in the abovementioned Example 1, except that $Bi_{1.7}Pb_{0.3}Sr_2Ca_2Cu_3O_y$ was used as the superconducting material and the film 8 of the superconducting material was heated to a temperature of 840°C for 80 hours.

Then, a critical temperature "Tc" and a critical current density "Jc" of the film 8 of the superconducting material were investigated. The result in shown in Table 2.

5

Table 2

| Mixing rate of oxygen gas into argon gas (vol.%) | 20 | 25 | 30 | 60 | 100 |
|---|---|---|---|---|---|
| Critical temperature "Tc" (K) | 80 | 90 | 100 | 100 | 105 |
| Critical current density "Jc" (A/cm$^2$) | 10 | 100 | 500 | 600 | 800 |

As is clear from Table 2, a film 8 having an excellent superconducting property including a "Tc" of at least 100 K and a "Jc" of at least 500 A/cm$^2$ was obtained by mixing the oxygen gas in an amount of at least 30 vol.% into the argon gas.

According to the method of the present invention, as described above, it is possible to reduce an amount of oxygen omission of a composite oxide superconducting material, thus making it possible to obtain a film of the superconducting material having an excellent superconducting property including a critical temperature "Tc" of at least 90 K and a critical current density "Jc" of at least 350 A/cm$^2$, thus providing industrially useful effects.

**Claims**

1. In a method for metallizing a superconducting material onto a surface of a substrate by the use of the plasma phenomenon, which comprises the steps of:

continuously supplying an operating gas into a bore of a metallizing nozzle from a rear end portion thereof;

continuously supplying powder of a composite oxide superconducting material containing a $Cu_xO_y$ radical into said bore of said metallizing nozzle from a tip portion thereof;

producing an electric arc between an electrode inserted into a rear end portion of said bore and an inner surface of said bore to convert said operating gas supplied into said bore into a high-temperature plasma;

melting said powder of said superconducting material supplied into said bore by means of said operating gas converted into said high-temperature plasma;

uniformly blowing the thus melted powder of said superconducting material from said metallizing nozzle onto a surface of a substrate by means of a jet of said operating gas converted into said high-temperature plasma, to form a film of said superconducting material onto said surface of said substrate; and

heating the thus formed film of said superconducting material to a temperature of at least 700°C, and then slowly cooling said film thus heated to the room temperature at a cooling rate of up to 40°C/minute;

the improvement characterized by:

mixing an oxygen gas in an amount of at least 30 vol.% into said operating gas.

2. The method as claimed in Claim 1, wherein:

said composite oxide superconducting material consists of $Y_1Ba_2Cu_3O_{7-y}$.

3. The method as claimed in Claim 1, wherein:

said composite oxide superconducting material consists of $Bi_{1.7}Pb_{0.3}Sr_2Ca_2Cu_3O_y$.

# FIG. 1

# FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | ADVANCED CERAMIC MATERIALS, vol. 2, no. 3B, special issue, 1987, pages 401-410, American Ceramic Society, Columbus, Ohio, US; J.P. KIRKLAND et al.: "Thermal spraying superconducting oxide coatings" --- | | C 23 C 4/10<br>C 04 B 35/00 |
| A | DE-A-2 155 217 (PHILIPS PATENTVERWALTUNG) --- | | |
| A | PATENT ABSTRACTS OF JAPAN, vol. 11, no. 262 (C-442)[2709], 25th August 1987; & JP-A-62 63 664 (NIPPON STEEL CORP.) 20-03-1987 --- | | |
| A | ADVANCED CERAMIC MATERIALS, vol. 2, no. 3B, special issue, 1987, pages 422-429, American Ceramic Society, Columbus, Ohio, US; J.J. CUOMO et al.: "Large area plasma spray deposited superconducting YBa2Cu3O7 thick films" --- | | |
| X,P | APPLIED PHYSICS LETTERS, vol. 52, no. 12, 21st March 1988, pages 1011-1013, American Institute of Physics, New York, NY, US; K. TACHIKAWA et al.: "High Tc superconducting films of Y-Ba-Cu oxides prepared by low-pressure plasma spraying" * Whole article * --- | 1 | TECHNICAL FIELDS SEARCHED (Int. Cl.4)<br><br>C 23 C<br>C 04 B |
| X,P | JOURNAL OF PHYSICS D: APPLIED PHYSICS, vol. 21, 1988, pages 1246-1249, Chemical Society, Letchworth, GB; J. KARTHIKEYAN et al.: "Plasma sprayed superconducting Y1Ba2Cu3O7-x coatings" * Page 1246, table 1 * --- -/- | 1,2 | |

The present search report has been drawn up for all claims

| Place of search | Date of completion of the search | Examiner |
|---|---|---|
| THE HAGUE | 19-04-1989 | ELSEN D.B.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)

European Patent
Office

**EUROPEAN SEARCH REPORT**

Application Number

EP  88 12 0829

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,P | EP-A-0 286 135  (SUMITOMO ELECTRIC INDUSTRIES)<br>* Claims 1,13-16; page 5, lines 7-11,40-43 * | 1 | |

TECHNICAL FIELDS
SEARCHED (Int. Cl.4)

The present search report has been drawn up for all claims

| Place of search | Date of completion of the search | Examiner |
|---|---|---|
| THE HAGUE | 19-04-1989 | ELSEN D.B.A. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)